# EUROPEAN PATENT APPLICATION

(11) **EP 4 764 510 A1**
(43) Date of publication of application: **24.06.2026**
(21) Application number: 24222020.0
(22) Date of filing: 20.12.2024
(51) Int. Cl.: G01R 27/02, G01R 31/34, G01R 31/12, H02K 15/02, G01R 31/16

(54) **STATOR INSULATION RESISTANCE TEST AND POST-PROCESSING METHOD**

(30) Priority: 18.12.2024 KR 20240189651
(71) Applicant: CNM Co., Ltd., Gimhae-si, Gyeongsangnam-do 50932 (KR)
(72) Inventor: Kim, Hyun Seok, Gyeongsangnam-do (KR); Han, Hyun Gyu, Gyeongsangnam-do (KR); Kwon, Sung Jin, Busan (KR); Lee, Jae Ung, Busan (KR)
(74) Representative: RGTH

(57) **Abstract**

The present invention relates to a method for testing insulation resistance of a stator, and a method for testing insulation resistance of a stator and performing post-processing includes:
a step of preparing a sample manually by an operator for a test;
a step of testing insulation resistance by measuring whether a resistance value is equal to or greater than a predetermined value by applying a predetermined test voltage after settling the sample in purified water and maintaining the sample under a predetermined pressure; a spin step of removing moisture at a predetermined rotation speed for a predetermined period of time by putting the tested sample in a device that provides rotational force;
an air-showering step of removing moisture from the sample by applying compressed air for a predetermined period of time; an induction-heating step of removing moisture by applying heat for a predetermined period of time;
a drying step of drying and removing moisture by applying hot air to the sample for a predetermined period of time; a cooling step of stabilizing the sample until the sample reaches room temperature; and
a step of removing the sample that has completed all of the steps and putting the sample into a manufacturing line by the operator.

According to the present invention, there can be provided a method for testing insulation resistance which is performed on a stator of a motor or a compressor and a method for quickly and efficiently putting the sample used in a completed test back into a manufacturing line.

## Description

### BACKGROUND OF THE INVENTION

### Field of the Invention

The present invention relates to a process and a method for testing insulation resistance of a stator and then putting the stator into a manufacturing process after post-processing is performed.

### Description of the Related Art

Rotary systems such as electric motors include a rotor and a stator.

The stator includes a stator core and a stator coil wound around the stator core. A covered wire covered with an insulating coating around a conducting wire is used as the stator coil wound around the stator core.

Here, when the stator coil is wound around the stator core, there is a possibility that the stator coil may be damaged and have an insulation defect. For example, there is a possibility that an insulation coating of the stator coil may be damaged due to contact between stator coils or between the stator coil and another component. In a case where a motor is manufactured by assembling a stator and a rotor in a state in which the stator coil is damaged (a state in which an insulation defect has occurred), there is a possibility that short circuit malfunction may occur at a damaged position of the stator coil and leads to overcurrent flow.

For this reason, there are proposed stator testing apparatuses that test insulation conditions of the stator coil wound around the stator core. For example, a stator testing apparatus disclosed in Patent Literature 1 (Japanese Unexamined Patent Publication No. H8-65965) is known.

The stator testing apparatus disclosed in Patent Literature 1 tests an insulation state of a stator coil by applying a test voltage to the stator coil and detects an insulation defect of the stator coil due to damage or the like.

Various methods are used for detecting an insulation defect in the stator coil. For example, a method of detecting corona discharge or glow discharge by a discharge detecting apparatus or naked eyes of an operator, a method of measuring a voltage waveform between stator coils, a method of measuring insulation resistance, and the like are used.

### Citation List

### Patent Literature

Patent Literature 1: Japanese Unexamined Patent Publication No. H8-65965

### SUMMARY OF THE INVENTION

The present invention is made to solve the above-described problems and provides a method for testing insulation resistance which is performed on a stator of a motor or a compressor and a method for quickly and efficiently introducing a sample used in a completed test back into a manufacturing line.

According to the present invention, there is provided a method for testing insulation resistance of a stator and performing post-processing, including: a step of preparing a sample manually by an operator for a test; a step of testing insulation resistance by measuring whether a resistance value is equal to or greater than a predetermined value by applying a predetermined test voltage after settling the sample in purified water and maintaining the sample under a predetermined pressure; a spin step of removing moisture at a predetermined rotation speed for a predetermined period of time by putting the tested sample in a device that provides rotational force; an air-showering step of removing moisture from the sample by applying compressed air for a predetermined period of time; an induction-heating step of removing moisture by applying heat for a predetermined period of time; a drying step of drying and removing moisture by applying hot air to the sample for a predetermined period of time; a cooling step of stabilizing the sample until the sample reaches room temperature; and a step of removing the sample that has completed all of the steps and putting the sample into a manufacturing line by the operator.

Meanwhile, the insulation resistance testing step includes:
a step of checking conductivity by settling the sample in purified water, a step of putting the sample into a vacuum tank, settling the sample in purified water, then causing a pressure to reach a predetermined pressure, and then maintaining the sample for a predetermined period of time, and a step of measuring a result value by connecting the sample to the stator and applying a predetermined voltage for a predetermined period of time after releasing a vacuum state.

Further, in the air-showering step,
the sample is put in a device including an outside nozzle through which compressed air is supplied to an outer surface of the stator, and
an inside nozzle through which compressed air is supplied to an inner circumferential surface of the stator, and compressed air is supplied at a predetermined pressure for a predetermined period of time to remove moisture from the sample.

Meanwhile, in the induction-heating step,
induction-heating is performed on the sample at a predetermined temperature for a predetermined period of time to remove moisture from the sample.

Further, in the drying step,
hot air is applied to the sample at a predetermined temperature for a predetermined period of time to remove moisture from the sample.

### BRIEF DESCRIPTION OF THE DRAWINGS

FIG. 1 is a view illustrating a configuration of an overall system that performs a stator insulation resistance test and post-processing process according to an embodiment of the present invention.
FIG. 2 is a view illustrating an IR test apparatus according to the embodiment of the present invention.
FIG. 3 is a view of a device that performs a spin step according to the embodiment of the present invention.
FIG. 4 is a view of a device that performs an air-showing step according to the embodiment of the present invention.
FIG. 5 is a view of a device that performs an induction-heating step according to the embodiment of the present invention.
FIG. 6 is a view of a device that performs a hot-air-drying step according to the embodiment of the present invention.

### DETAILED DESCRIPTION OF THE PREFERRED EMBODIMENTS

The present invention, operational advantages of the present invention, and an object achieved by implementing the present invention will be fully understood with reference to the accompanying drawings illustrating preferred embodiments of the present invention and details described in the accompanying drawings.

Hereinafter, the invention will be described in detail by describing the preferred embodiment of the present invention with reference to the accompanying drawings. However, the present invention can be realized as various different examples and is not limited to the embodiments described here. Further, parts unrelated to the description are omitted to clearly describe the present invention, and the same reference numerals in the drawings indicate the same members.

Hereinafter, various embodiments of this document will be described with reference to the accompanying drawings. However, a technology described in this document is not limited to a specific example, but is to be understood to include various modifications, equivalents, and/or alternatives of the embodiments of this document. Regarding the description of the drawings, similar reference numerals can be assigned to similar configurational elements.

In this document, expressions such as "comprise," or "may comprise" indicate presence of a feature (for example, a numerical value, a function, an operation, or a configurational element such as a component) and do not exclude presence of an additional feature.

Terms used in this document are only used to describe a specific embodiment and may not intentionally be used to limit the scope of another embodiment. A word having a singular form can include a meaning of its plural form, unless obviously implied otherwise in context. Terms used herein including technical or scientific terms can have the same meanings as those generally understood by those of ordinary skill in the art described in this document. Of the terms used in this document, terms defined in general dictionaries can be construed to have the same or similar meanings as the contextual meanings in the related art. In addition, unless clearly defined in this document, the terms should not be construed to have ideal or excessively formal meanings. In some cases, the terms defined in this document cannot be construed to exclude the embodiments of this document.

It is needless to say that various modified examples of the present invention can be made by a person of ordinary skill in the art to which the corresponding invention pertains without departing from the gist of the present invention claimed in the claims of the present invention, and the various modified examples are not to be understood separately from the technical ideas or prospects of the present invention.

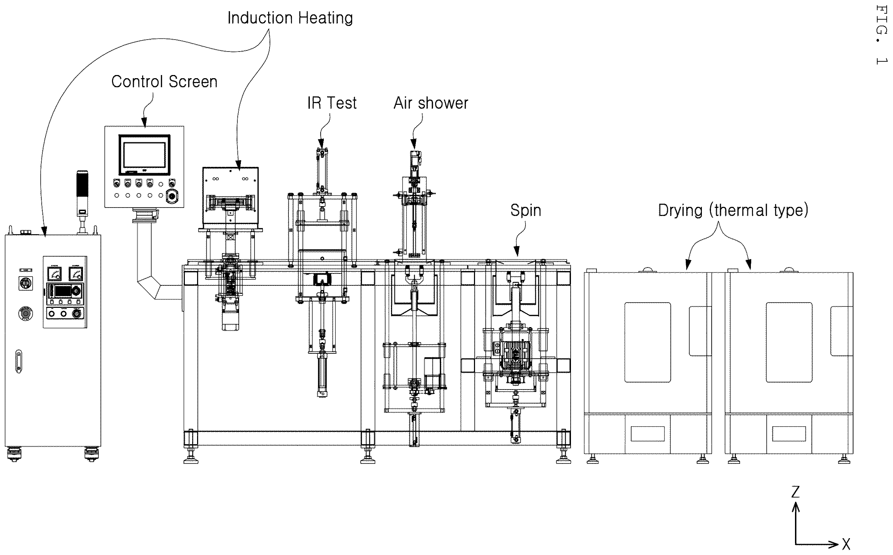

FIG. 1 is a view illustrating a configuration of an overall system that performs a stator insulation resistance test and post-processing process according to an embodiment of the present invention.

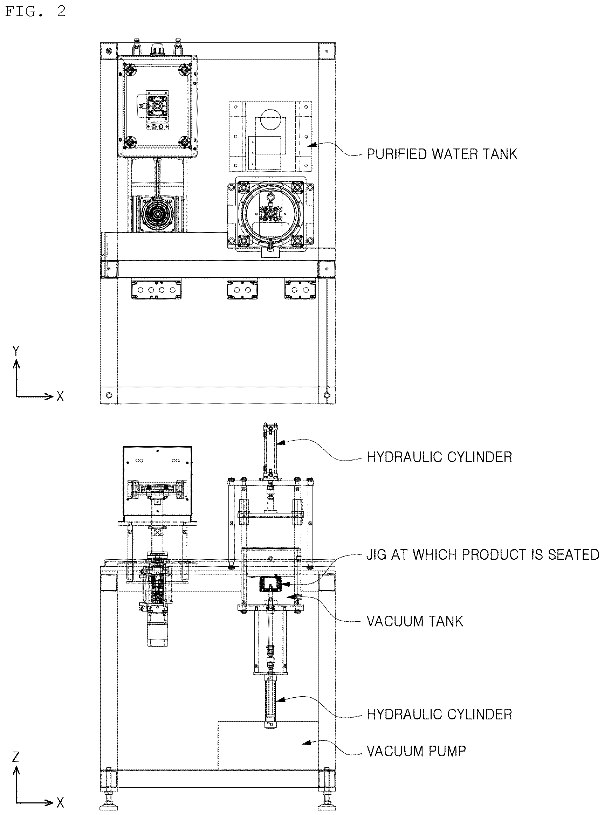

FIG. 2 is a view illustrating an IR test apparatus according to the embodiment of the present invention.

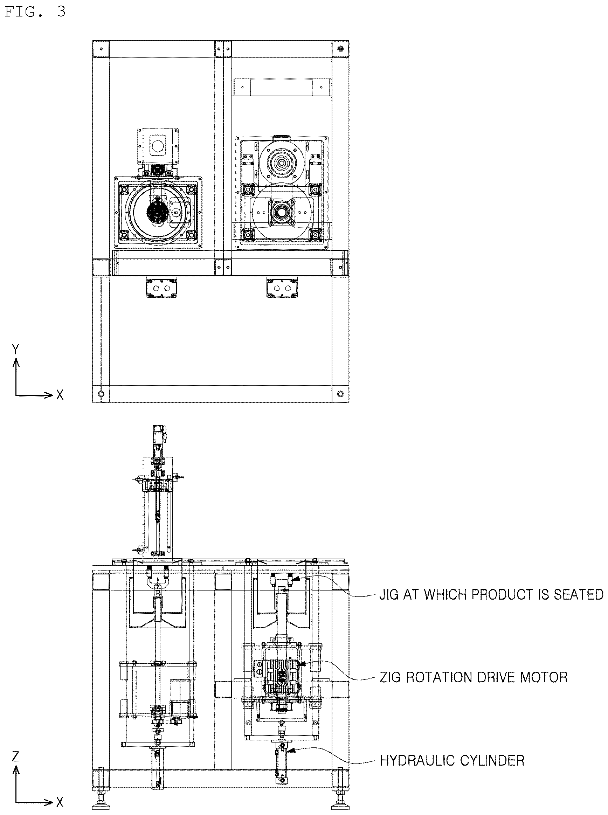

FIG. 3 is a view of a device that performs a spin step according to the embodiment of the present invention.

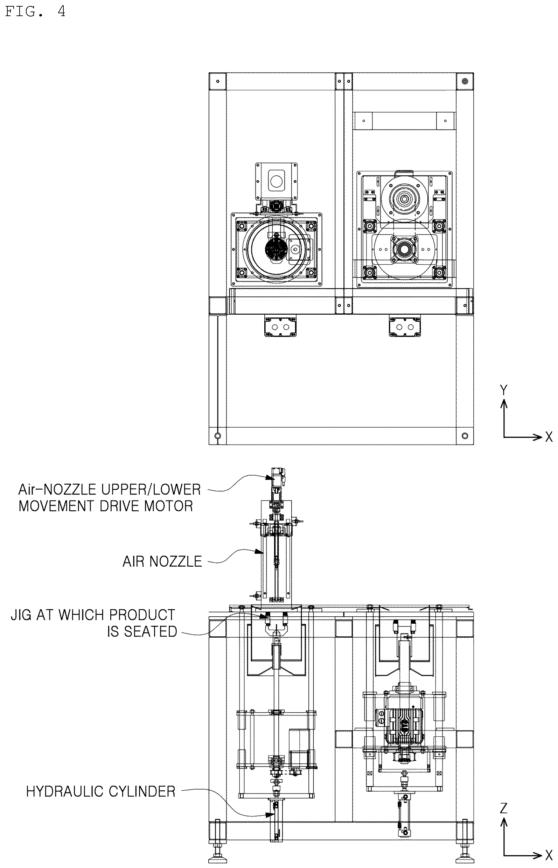

FIG. 4 is a view of a device that performs an air-showing step according to the embodiment of the present invention.

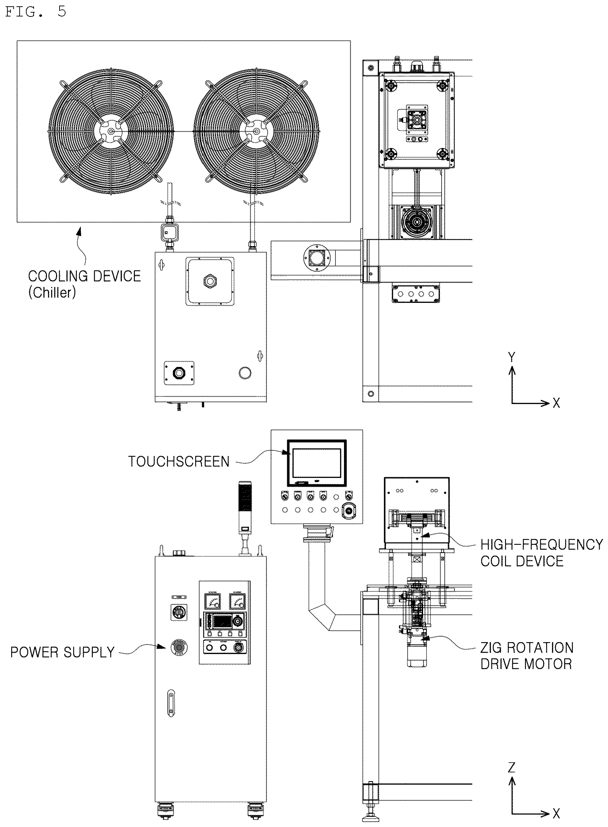

FIG. 5 is a view of a device that performs an induction-heating step according to the embodiment of the present invention.

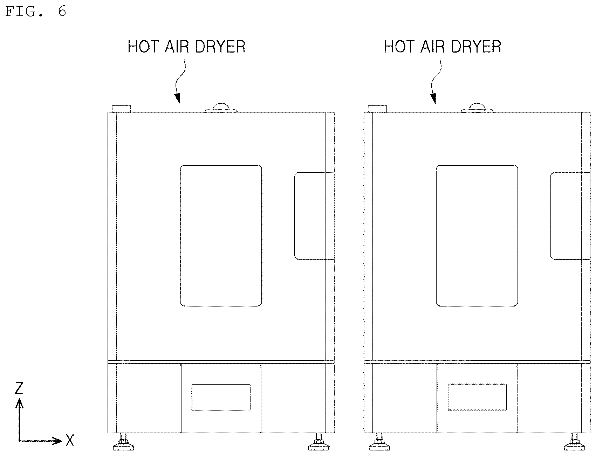

FIG. 6 is a view of a device that performs a hot-air-drying step according to the embodiment of the present invention.

A stator insulation resistance test and post-processing method according to the embodiment of the present invention is carried out through the following process.

According to the embodiment of the present invention, the method for testing insulation resistance of a stator and performing post-processing starts from a step of preparing a sample manually by an operator for a test.

Next, a step of testing insulation resistance by measuring whether a resistance value is equal to or greater than a predetermined value by applying a predetermined test voltage after settling the sample in purified water and maintaining the sample under a predetermined pressure.

The insulation resistance testing step is performed in dedicated insulation resistance (IR) test equipment.

The IR test equipment includes a purified water tank that stores purified water and provides the stored purified water in response to a controlled command, a jig at which the sample, that is, the stator, is seated, and hydraulic cylinders that are provided on upper and lower sides of the jig and operate the jig in a vertical direction using hydraulic pressure.

Meanwhile, a vacuum tank is provided on one side of the jig. The jig is seated by operations of the hydraulic cylinders, and a cover is positioned to perform opening or closing by the operations of the hydraulic cylinders when a predetermined amount of purified water is put into the vacuum tank from the purified water tank.

Further, on one side of the vacuum tank, a vacuum pump that creates a vacuum state inside the vacuum tank is provided.

The IR test equipment includes the above-described components.

Using the IR test equipment, a step of checking conductivity by settling the sample in the purified water is performed.

Next, the sample is put into the vacuum tank. After the sample is put into the vacuum tank, the sample is settled in the purified water. The amount of purified water to be supplied therein is checked to be a required amount by using a sensor provided inside, and the supply amount is controlled.

Then, the vacuum is operated to create a vacuum state inside the vacuum pump. In the embodiment of the present invention, the vacuum pump is operated until an internal pressure reaches 230 mbar. It takes about 5 seconds to reach the pressure.

When a predetermined pressure (in the embodiment of the present invention, 230 mbar) is reached, the pressure is maintained for a predetermined period of time. In the present invention, the pressure is maintained for 5 seconds or longer.

Next, after the vacuum state is released, a terminal for the IR test is connected to an end pin provided on the stator. Further, the IR test is conducted.

In the embodiment of the present invention, a voltage of the IR test applied to the sample is 950 V DC voltage, and a test result is used to check whether a predetermined resistance value is measured after applying the voltage for a predetermined time (in the embodiment of the present invention, for 5 seconds or longer).

After the IR test is completed, the vacuum state is released by the operation of the vacuum pump, and the purified water supplied into the vacuum tank returns to the purified water tank by an operation of a separately provided circulation pump.

Meanwhile, one or more purified water tanks can be provided, purified water tanks may include an upper purified water tank provided above the vacuum tank and a lower purified water tank provided below the vacuum tank, and a plurality of purified water tanks can be provided as necessary.

Next, steps of removing the purified water used in the IR test are performed on the tested sample.

First, a spin step of removing moisture with centrifugal force from the rotation is performed.

In the spin step, the sample is rotated by driving force of the motor after the sample is seated. The step of removing moisture from the sample with the centrifugal force generated due to rotational force provided by the motor is performed.

Here, in the embodiment of the present invention, the step is performed for 20 seconds at 1,500 rpm.

Next, an air-showering step of removing moisture from the sample by applying compressed air for a predetermined period of time is performed.

Here, a step of removing moisture from the sample by putting the sample in a device including an outside nozzle through which compressed air is supplied to an outer surface of the stator and an inside nozzle through which compressed air is supplied to an inner circumferential surface of the stator, and supplying the compressed air at a predetermined pressure for a predetermined period of time is performed

Here, in the embodiment of the present invention, the compressed air of 4 bar or higher is supplied to the sample, and it is preferable that the compressed air be supplied in a state in which the sample is rotated.

Next, an induction-heating step of removing moisture by applying heat for a predetermined period of time is performed.

Here, moisture infiltrating between individual core sheets of the stator having a layered configuration can be removed by applying induction heat to the sample. Here, in the embodiment of the present invention, it is preferable to perform heating to 120 to 130 degrees through the induction heating and maintain this state for about 20 seconds.

Next, a drying step of drying and removing moisture by applying hot air to the sample for a predetermined period of time is performed.

Here, the hot air is applied to the sample in a state of 120 to 130 degrees for 20 minutes or longer. Through such a process, it becomes possible to efficiently perform an operation of removing the moisture remaining between individual core sheets.

Next, a cooling step of stabilizing the sample until the sample that has completed the steps reaches room temperature and a step of removing the sample that has completed all of the steps and putting the sample into a manufacturing line by the operator are performed.

According to the steps and configurations described above, the insulation resistance test method conducted on the stator of the motor or the compressor is provided, and the efficient test method and configuration enabling the tested sample to be quickly and efficiently put into a manufacturing line can be provided.

According to a method of an embodiment of the present invention, there is provided an insulation resistance test method conducted on a stator of a motor or a compressor, and there can be provided an efficient test method and system enabling the tested sample to be quickly and efficiently put into a manufacturing line.

While the present invention has been described with respect to the specific embodiments, it will be apparent to those skilled in the art that various changes and modifications may be made without departing from the spirit and scope of the invention as defined in the following claims.

## Claims

1. A method for testing insulation resistance of a stator and performing post-processing, comprising:
a step of preparing a sample manually by an operator for a test;
a step of testing insulation resistance by measuring whether a resistance value is equal to or greater than a predetermined value by applying a predetermined test voltage after settling the sample in purified water and maintaining the sample under a predetermined pressure;
a spin step of removing moisture at a predetermined rotation speed for a predetermined period of time by putting the tested sample in a device that provides rotational force;
an air-showering step of removing moisture from the sample by applying compressed air for a predetermined period of time;
an induction-heating step of removing moisture by applying heat for a predetermined period of time;
a drying step of drying and removing moisture by applying hot air to the sample for a predetermined period of time;
a cooling step of stabilizing the sample until the sample reaches room temperature; and
a step of removing the sample that has completed all of the steps and putting the sample into a manufacturing line by the operator.

2. The method for testing insulation resistance of a stator and performing post-processing according to claim 1,
wherein the insulation resistance testing step includes:
a step of checking conductivity by settling the sample in purified water;
a step of putting the sample into a vacuum tank, settling the sample in purified water, then causing a pressure to reach a predetermined pressure, and then maintaining the sample for a predetermined period of time; and
a step of measuring a result value by connecting the sample to the stator and applying a predetermined voltage for a predetermined period of time after releasing a vacuum state.

3. The method for testing insulation resistance of a stator and performing post-processing according to claim 2,
wherein, in the air-showering step,
the sample is put in a device including an outside nozzle through which compressed air is supplied to an outer surface of the stator, and
an inside nozzle through which compressed air is supplied to an inner circumferential surface of the stator, and
compressed air is supplied at a predetermined pressure for a predetermined period of time to remove moisture from the sample.

4. The method for testing insulation resistance of a stator and performing post-processing according to claim 2,
wherein, in the induction-heating step,
induction-heating is performed on the sample at a predetermined temperature for a predetermined period of time to remove moisture from the sample.

5. The method for testing insulation resistance of a stator and performing post-processing according to claim 2,
wherein, in the drying step,
hot air is applied to the sample at a predetermined temperature for a predetermined period of time to remove moisture from the sample.
